# FASCICULE DE BREVET EUROPEEN

(11) **EP 3 991 215 B1**
(45) Date de publication et mention de la délivrance du brevet: **13.08.2025**
(21) Numéro de dépôt: 20734741.0
(22) Date de dépôt: 25.06.2020
(51) Int. Cl.: H10H 20/01, H10H 20/818, H10H 20/819, H10H 20/812, H10H 20/813, H10H 20/816, H10H 20/825

(54) **DISPOSITIF OPTOÉLECTRONIQUE À DIODES ÉLECTROLUMINESCENTES DE TYPE AXIAL ET SON PROCÉDÉ DE FABRICATION**
OPTOELEKTRONISCHE VORRICHTUNG MIT LEUCHTDIODEN DES AXIALEN TYPS UND HERSTELLUNGSVERFAHREN DAFÜR
OPTOELECTRONIC DEVICE WITH AXIAL-TYPE LIGHT-EMITTING DIODES AND METHOD FOR MANUFACTURING THE SAME

(30) Priorité: 25.06.2019 FR 1906899
(43) Date de publication de la demande: 04.05.2022
(73) Titulaire: Aledia, 38130 Echirolles (FR); Commissariat à l'Energie Atomique et aux Energies Alternatives, 75015 Paris (FR); Université Grenoble Alpes, 38400 Saint-Martin-d'Hères (FR)
(72) Inventeur: GRUART, Marion, 38120 Saint-Égrève (FR); DAUDIN, Bruno-Jules, 38054 Grenoble Cedex 9 (FR); CHIKHAOUI, Walf, 38500 Voiron (FR)
(74) Mandataire: Cabinet Beaumont
(86) Numéro de dépôt international: PCT/EP2020/067969
(87) Numéro de publication internationale: WO 2020/260548

(56) Documents cités:
- EP-B1- 2 290 710
- KR-A- 20110 117 963
- US-A1- 2007 248 132
- US-A1- 2018 351 037
- FOXON C T ET AL: "A complementary geometric model for the growth of GaN nanocolumns prepared by plasma-assisted molecular beam epitaxy", JOURNAL OF CRYSTAL GROWTH, ELSEVIER, AMSTERDAM, NL, vol. 311, no. 13, 15 June 2009 (2009-06-15), pages 3423 - 3427, XP026185464, ISSN: 0022-0248, [retrieved on 20090503], DOI: 10.1016/J.JCRYSGRO.2009.04.021
- KISHINO KATSUMI ET AL: "Green-Light Nanocolumn Light Emitting Diodes With Triangular-Lattice Uniform Arrays of InGaN-Based Nanocolumns", IEEE JOURNAL OF QUANTUM ELECTRONICS, IEEE SERVICE CENTER, PISCATAWAY, NJ, USA, vol. 50, no. 7, 1 July 2014 (2014-07-01), pages 538 - 547, XP011549884, ISSN: 0018-9197, [retrieved on 20140603], DOI: 10.1109/JQE.2014.2325013
- STEFFI Y WOO ET AL: "Interplay of strain and indium incorporation in InGaN/GaN dot-in-a-wire nanostructures by scanning transmission electron microscopy", NANOTECHNOLOGY, INSTITUTE OF PHYSICS PUBLISHING, GB, vol. 26, no. 34, 3 August 2015 (2015-08-03), pages 344002, XP020287868, ISSN: 0957-4484, [retrieved on 20150803], DOI: 10.1088/0957-4484/26/34/344002

## Description

La présente demande de brevet revendique la priorité de la demande de brevet français FR19/06899.

### Domaine technique

La présente invention concerne de façon générale les dispositifs optoélectroniques à diodes électroluminescentes comprenant des éléments semiconducteurs tridimensionnels, par exemple des microfils, des nanofils, des éléments coniques, tronconiques, pyramidaux, ou pyramidaux tronqués de taille micrométrique ou nanométrique et les procédés de fabrication de tels dispositifs.

### Technique antérieure

On considère ici plus particulièrement l'amélioration des dispositifs optoélectroniques à diodes électroluminescentes du type axial, comprenant une zone active formée au sommet de chaque élément tridimensionnel. On appelle zone active de la diode électroluminescente la région depuis laquelle est émise la majorité du rayonnement électromagnétique fourni par la diode électroluminescente.

Les éléments tridimensionnels considérés ici comprennent un matériau semiconducteur comportant majoritairement un élément du groupe III et un élément du groupe V (par exemple du nitrure de gallium GaN), appelé par la suite composé III-V. De tels dispositifs sont, par exemple, décrits dans le brevet US 9 728 680 B2.

Chaque zone active est prise en sandwich entre l'élément semiconducteur tridimensionnel associé, qui est généralement dopé d'un premier type de conductivité, et une couche semiconductrice du même composé III-V que l'élément semiconducteur et dopée du type de conductivité opposé.

Selon un exemple, la zone active peut comporter des moyens de confinement. La zone active peut comprendre au moins un puits quantique comprenant une couche d'un matériau semiconducteur ayant une énergie de bande interdite inférieure à celle de l'élément semiconducteur tridimensionnel et de la couche semiconductrice, de préférence interposée entre deux couches barrières, améliorant ainsi le confinement des porteurs de charge, les couches barrières pouvant être du même matériau que l'élément semiconducteur tridimensionnel et non intentionnellement dopées. Chaque puits quantique peut comprendre un alliage ternaire comprenant un premier élément du groupe III, qui correspond généralement à l'élément du groupe III du composé III-V, l'élément du groupe V du composé III-V, et au moins un deuxième élément du groupe III et chaque couche barrière peut comprendre le composé III-V.

Les demandes de brevet: KR 2011 0117963 A et US 2018/0351037 A1, ainsi que l'article de K. Kishino et al. intitulé: "Green-Light Nanocolumn Light Emitting Diodes With Triangular-Lattice Uniform Arrays of InGaN-Based Nanocolumns", IEEE Journal of Quantum Electronics, Vol. 50, No. 7, juillet 2014, pages 538-547, divulguent des dispositifs à diodes électroluminescentes de type axial à base de composés semiconducteurs en nitrures d'éléments du groupe III, ainsi que leurs procédés de fabrication.

La zone active peut comprendre un empilement de puits quantiques pour augmenter la quantité de lumière émise par la zone active. Toutefois, en raison notamment du fait que la longueur de diffusion des trous est nettement inférieure à la longueur de diffusion des électrons, seule une partie des puits quantiques de la zone active peut émettre de la lumière en fonctionnement.

### Résumé de l'invention

Ainsi, un objet de l'invention est de pallier au moins en partie les inconvénients des dispositifs optoélectroniques décrits précédemment et de leurs procédés de fabrication.

Un autre objet de l'invention selon un mode de réalisation est d'améliorer les performances d'émission du dispositif optoélectronique à diodes électroluminescentes du type axial.

La présente invention concerne un dispositif optoélectronique selon la revendication 1 en annexe, comprenant une ou des diodes électroluminescentes, chaque diode électroluminescente comprenant un élément semiconducteur tridimensionnel, une zone active reposant sur l'élément semiconducteur tridimensionnel et un empilement de couches semiconductrices recouvrant la zone active, la zone active comprenant une pluralité de puits quantiques, ledit empilement étant au contact physique direct de plusieurs puits quantiques.

Dans le dispositif optoélectronique selon la présente invention, chaque zone active comprend une base, des flancs, et un sommet, la base reposant sur l'élément semiconducteur tridimensionnel, les puits quantiques comprenant des bords exposés sur les flancs, ledit empilement recouvrant les flancs et le sommet.

En outre, dans le dispositif optoélectronique selon la présente invention, chaque zone active a une forme de pyramide ou pyramide tronquée de demi-angle au sommet β dont la base repose sur l'élément semiconducteur tridimensionnel.

Selon un mode de réalisation de la présente invention, l'angle β est strictement supérieur à 0°, de préférence compris entre 5° et 80°, plus préférentiellement compris entre 20° et 30°.

Selon un mode de réalisation de la présente invention, l'empilement de couches semiconductrices comprend une paroi latérale parallèle à la direction de croissance C des matériaux cristallins composant les couches semiconductrices de l'empilement.

Selon un mode de réalisation de la présente invention, les éléments semiconducteurs tridimensionnels s'étendent selon des axes parallèles, et comprennent chacun une portion inférieure et une portion supérieure évasée par rapport à la portion inférieure et inscrite dans un tronc de cône de demi-angle au sommet α.

Selon un mode de réalisation de la présente invention, l'angle α est strictement supérieur à 0°, de préférence compris entre 5° et 50°, plus préférentiellement compris entre 5° et 30°.

Selon un mode de réalisation de la présente invention, au moins une partie de chaque élément semiconducteur tridimensionnel est un microfil, un nanofil, ou un élément tronconique de taille micrométrique ou nanométrique.

Selon un mode de réalisation de la présente invention, les éléments semiconducteurs tridimensionnels comprennent un composé III-V.

Selon un mode de réalisation de la présente invention, les éléments semiconducteurs tridimensionnels sont dopés de type n.

Selon un mode de réalisation de la présente invention, chaque empilement comprend une couche semiconductrice en un composé III-V dopé de type p.

Selon un mode de réalisation de la présente invention, chaque empilement comprend au moins une couche de blocage d'électrons.

Selon un mode de réalisation de la présente invention, chaque puits quantique comprend un alliage ternaire comprenant un premier élément du groupe III, l'élément du groupe V du composé III-V, et un deuxième élément du groupe III.

Selon un mode de réalisation de la présente invention, le dispositif comprend de trois à dix puits quantiques.

Selon un mode de réalisation de la présente invention, ledit empilement est au contact physique direct de chaque puits quantique.

La présente invention concerne également un procédé de fabrication, selon la revendication 14 en annexe, d'un dispositif optoélectronique comprenant une ou des diodes électroluminescentes, comprenant, pour chaque diode électroluminescente, la formation d'un élément semiconducteur tridimensionnel, la formation d'une zone active reposant sur l'élément semiconducteur tridimensionnel et la formation d'un empilement de couches semiconductrices recouvrant la zone active, la zone active comprenant une pluralité de puits quantiques, ledit empilement étant au contact physique direct de plusieurs puits quantiques, dans lequel chaque zone active comprend une base, des flancs, et un sommet, la base reposant sur l'élément semiconducteur tridimensionnel, les puits quantiques comprenant des bords exposés sur les flancs, ledit empilement recouvrant les flancs et le sommet, et dans lequel chaque zone active a une forme de pyramide ou de pyramide tronquée de demi-angle au sommet β dont la base repose sur l'élément semiconducteur tridimensionnel.

Selon un mode de réalisation de la présente invention, les éléments semiconducteurs tridimensionnels comprennent un composé III-V. Chaque puits quantique comprend un alliage ternaire comprenant un premier élément du groupe III, l'élément du groupe V du composé III-V, et un deuxième élément du groupe III. Les puits quantiques sont séparés par des couches barrières comprenant le composé III-V, et, pour la croissance de chaque couche barrière, le rapport entre le flux atomique de l'élément du groupe III du composé III-V et le flux atomique de l'élément du groupe V est inférieur à 1.

Ainsi, un mode de réalisation prévoit un procédé de fabrication d'un dispositif optoélectronique comprenant des diodes électroluminescentes comprenant la formation d'éléments semiconducteurs tridimensionnels, s'étendant selon des axes parallèles, en un composé III-V, et comprenant chacun une portion inférieure et une portion supérieure évasée par rapport à la portion inférieure et inscrite dans un tronc de cône de demi-angle au sommet α. Le procédé comprend en outre, pour chaque élément semiconducteur, la formation d'une zone active selon la présente invention telle que revendiquée, recouvrant le sommet de la portion supérieure et la formation d'au moins une couche semiconductrice du composé III-V recouvrant la zone active par dépôt sous phase vapeur à une pression inférieure à 10 mPa, en utilisant un flux de l'élément du groupe III selon une première direction inclinée d'un angle θ_{III} et un flux de l'élément du groupe V selon une deuxième direction inclinée d'un angle θᵥ par rapport à l'axe vertical, le plus grand des deux angles θ_{III} et θᵥ étant inférieur strictement à l'angle α.

Selon un mode de réalisation, les couches semiconductrices sont formées par épitaxie par jets moléculaires.

Selon un mode de réalisation, le rapport III/V, pour la formation des couches semiconductrices, est inférieur à 1,4, de préférence inférieur à 1,3.

Selon un mode de réalisation, l'angle α est strictement supérieur à 0°, de préférence compris entre 5° et 50°, plus préférentiellement compris entre 5° et 30°.

Selon un mode de réalisation, les portions supérieures des éléments semiconducteurs tridimensionnels sont formées par épitaxie par jets moléculaires.

Selon un mode de réalisation, le rapport III/V, pour la formation des portions supérieures des éléments semiconducteurs tridimensionnels, est supérieur à 1,1.

Selon un mode de réalisation, les portions inférieures des éléments semiconducteurs tridimensionnels sont formées par épitaxie par jets moléculaires.

Selon un mode de réalisation, le rapport III/V, pour la formation des portions inférieures des éléments semiconducteurs tridimensionnels, est inférieur à 1,4.

Selon un mode de réalisation, la température lors de la formation des portions supérieures des éléments semiconducteurs tridimensionnels est inférieure d'au moins 50°C à la température lors de la formation des portions inférieures des éléments semiconducteurs tridimensionnels.

Selon un mode de réalisation, les zones actives sont formées par épitaxie par jets moléculaires.

Selon un mode de réalisation, les portions inférieures des éléments semiconducteurs tridimensionnels sont des microfils, des nanofils, des éléments coniques de taille micrométrique ou nanométrique, ou des éléments tronconiques ou pyramidaux de taille micrométrique ou nanométrique.

Selon un mode de réalisation, les zones actives sont les régions depuis lesquelles est émise la majorité du rayonnement électromagnétique fourni par les diodes électroluminescentes.

### Brève description des dessins

Ces caractéristiques et avantages, ainsi que d'autres, seront exposés en détail dans la description suivante de modes de réalisation particuliers, certains modes étant suivant la présente invention telle que revendiquée tandis que d'autres ne le sont pas mais leur exposé étant nécessaire pour comprendre le contexte de la présente invention, faite à titre non limitatif en relation avec les figures jointes parmi lesquelles :
la figure 1 est une vue en coupe, partielle et schématique, d'un exemple d'un dispositif optoélectronique à diodes électroluminescentes du type axial ne faisant pas partie de la présente invention mais illustrant son contexte;
la figure 2 représente des courbes d'évolution, obtenues par simulations, de la densité de courant dans des puits quantiques d'une zone active d'une diode électroluminescente du dispositif optoélectronique à diodes électroluminescentes ;
les figures 3 à 6 représentent chacune un mode de réalisation d'un dispositif optoélectronique à diodes électroluminescentes du type axial, les modes des figures 3 et 6 étant selon la présente invention telle que revendiquée, tandis que les modes des figures 4 et 5 ne définissent pas, en soi, la présente invention telle que revendiquée mais illustrent son contexte ;
les figures 7A à 7D sont des vues en coupe, partielles▪et schématiques, de structures obtenues à des étapes successives d'un mode de réalisation d'un procédé, ne définissant pas en soi la présente invention telle que revendiquée mais illustrant son contexte, de fabrication du dispositif optoélectronique représenté en figure 5 ;
la figure 8 est une image obtenue par microscopie électronique à balayage d'une partie du dispositif de la figure 5 ;
les figures 9 et 10 contiennent chacune des images obtenues par TEM et par EDX de l'extrémité d'une diode électroluminescente du dispositif optoélectronique selon la présente invention représenté en figure 3 ; et
la figure 11 est une image en courant EBIC de l'extrémité d'une diode électroluminescente du dispositif optoélectronique selon la présente invention représenté en figure 3.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques. Par souci de clarté, seuls les étapes et éléments utiles à la compréhension des modes de réalisation décrits ont été représentés et sont détaillés. En particulier, les moyens de commande des dispositifs optoélectroniques sont bien connus et ne sont pas décrits.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un dispositif optoélectronique dans une position normale d'utilisation. Dans la suite de la description, on considère qu'un élément a une "forme cylindrique" lorsqu'il correspond à un solide délimité par une surface cylindrique et par deux plans parallèles, une surface cylindrique étant une surface engendrée par une droite mobile tournant autour d'un axe auquel elle est parallèle. De ce fait, une forme prismatique est un exemple particulier de forme cylindrique. Dans la suite de la description, on considère qu'un élément a une "forme conique" lorsqu'il correspond à un cône, c'est-à-dire un solide délimité par un plan et une surface conique, une surface conique étant une surface engendrée par une droite passant par un point fixe appelé sommet et un point variable décrivant une courbe fermée, le plan ne contenant pas le sommet et coupant la surface conique. De plus, on considère qu'un élément a une "forme tronconique" lorsqu'il correspond à un cône dont la partie supérieure, contenant le sommet, a été retirée.

On entend par alliage ternaire un alliage formé essentiellement de trois éléments (par exemple deux éléments du groupe III et un élément du groupe V) mais bien entendu cet alliage peut être associé avec d'autres éléments (par exemple du groupe III) et former alors un alliage plus complexe par exemple un alliage quaternaire.

Sauf précision contraire, les expressions "environ", "approximativement", "sensiblement", et "de l'ordre de" signifient à 10 % près, de préférence à 5 % près. En outre, on considère ici que les termes "isolant" et "conducteur" signifient respectivement "isolant électriquement" et "conducteur électriquement".

La présente description concerne des dispositifs optoélectroniques comprenant des éléments semiconducteurs tridimensionnels, par exemple des microfils, des nanofils, des éléments coniques de taille micrométrique ou nanométrique, ou des éléments tronconiques de taille micrométrique ou nanométrique. En particulier, un élément conique ou tronconique peut être un élément conique circulaire ou tronconique circulaire ou un élément conique pyramidal ou tronconique pyramidal. Dans la suite de la description, des modes de réalisation sont décrits pour des dispositifs optoélectroniques comprenant des microfils ou des nanofils. Toutefois, ces modes de réalisation peuvent être mis en oeuvre pour des éléments semiconducteurs autres que des microfils ou des nanofils, par exemple des éléments coniques ou tronconiques.

Le terme "microfil", "nanofil", "élément conique" ou "élément tronconique" désigne une structure tridimensionnelle de forme allongée, par exemple cylindrique, conique ou tronconique, selon une direction privilégiée, appelée axe par la suite, dont au moins deux dimensions, appelées dimensions mineures, sont comprises entre 5 nm et 2,5 µm, de préférence entre 50 nm et 1 µm, la troisième dimension, appelée dimension majeure, étant supérieure ou égale à 1 fois, de préférence supérieure ou égale à 5 fois et encore plus préférentiellement supérieure ou égale à 10 fois, la plus grande des dimensions mineures, par exemple comprise entre 1 µm et 50 µm.

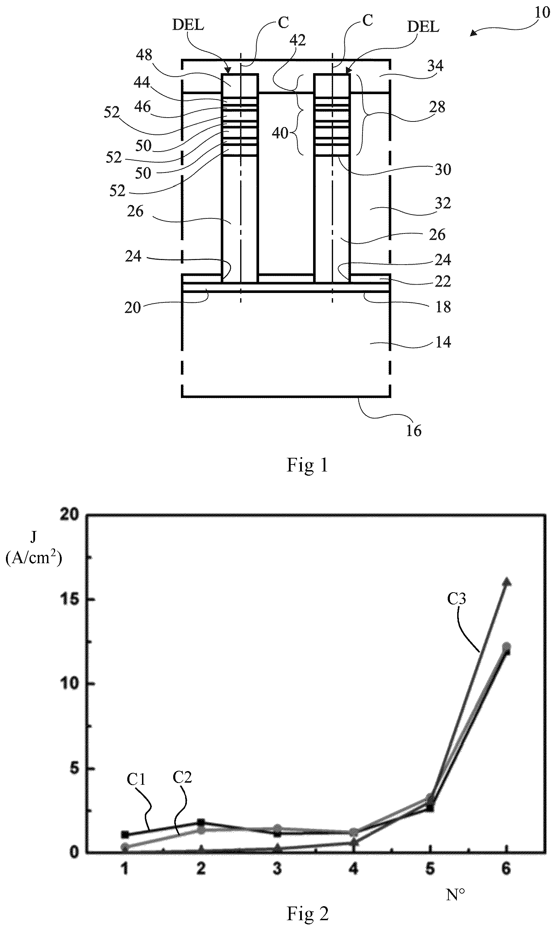

La figure 1 est une vue en coupe, partielle et schématique, d'un exemple d'un dispositif optoélectronique 10 à diodes électroluminescentes de type axial, ne faisant pas partie de la présente invention mais illustrant son contexte. Le dispositif optoélectronique 10 comprend du bas vers le haut en figure 1 :
- un substrat 14, par exemple un substrat semiconducteur, comprenant des faces parallèles 16 et 18, de préférence planes, la face 18 étant traitée pour promouvoir la croissance de fils. Ce traitement est représenté de façon schématique en figure 1 par une couche 20 de germination en un matériau favorisant la croissance des fils, sur la face 18 du substrat 14 ;
- une couche isolante 22 recouvrant la couche de germination 20 et comprenant des ouvertures 24 traversantes ;
- des fils 26 d'axes C parallèles, deux fils 26 étant représentés sur la figure 1 au moins en partie dopés d'un premier type de conductivité, par exemple dopés de type n ;
- pour chaque fil 26, une tête 28 recouvrant le sommet 30 du fil 26 ;
- une couche isolante 32 recouvrant les faces latérales des fils 26 et partiellement les faces latérales des têtes 28 ; et
- une couche d'électrode 34 recouvrant la couche isolante 32 et en contact avec les têtes 28.

Le dispositif optoélectronique 10 comprend une autre électrode, non représentée, pour polariser la base des fils 26.

Chaque tête 28 comprend du bas vers le haut en figure 1 :
- une zone active 40 recouvrant le sommet 30 du fil 26 ; et
- un empilement semiconducteur 42 recouvrant la zone active 40 et comprenant une couche semiconductrice 44 dopée d'un deuxième type de conductivité opposé à celui du fil 26, par exemple dopée de type p, et recouvrant la zone active 40.

L'ensemble formé par chaque fil 26 et la tête 28 associée forme une diode électroluminescente DEL en configuration axiale.

L'empilement semiconducteur 42 peut en outre comprendre une couche de blocage d'électrons 46 entre la zone active 40 et la couche semiconductrice 44 et une couche semiconductrice de liaison 48 recouvrant la couche semiconductrice 44 du côté opposé à la zone active 40, la couche de liaison 48 étant recouverte par la couche d'électrode 34. La couche de blocage d'électrons 46 en contact avec la zone active 40 et la couche semiconductrice 44 permet d'optimiser la présence des porteurs électriques dans la zone active 40. La couche de liaison 48 peut être du même matériau que la couche semiconductrice 44 et dopée du même type de conductivité que la couche semiconductrice 44 mais avec une concentration de dopants plus importante pour permettre la formation d'un contact ohmique entre la couche semiconductrice 44 et la couche d'électrode 34.

La zone active 40 est la zone de la diode électroluminescente DEL depuis laquelle est émise la majorité du rayonnement électromagnétique fourni par la diode électroluminescente DEL. Selon un exemple, la zone active 40 comporte des moyens de confinement. La zone active 40 peut comprendre au moins un puits quantique, comprenant une couche d'un matériau semiconducteur ayant une énergie de bande interdite inférieure à celle du fil 26 et de la couche semiconductrice 44, de préférence interposée entre deux couches barrières, améliorant ainsi le confinement des porteurs de charge, les couches barrières pouvant être du même matériau que le fil 26 et non intentionnellement dopées. La zone active 40 peut comprendre un empilement de puits quantiques pour augmenter la quantité de lumière émise par la zone active. A titre d'exemple, en figure 1, on a représenté une alternance selon l'axe C de deux puits quantiques 50 et de trois couches barrières 52. De préférence, la zone active 40 comprend entre trois et dix puits quantiques 50, de préférence environ dix puits quantiques 50.

Toutefois, en raison notamment du fait que la longueur de diffusion des trous est nettement inférieure à la longueur de diffusion des électrons, seule une partie des puits quantiques de la zone active 40 peut émettre de la lumière en fonctionnement. Dans le cas où les fils 26 sont dopés de type n et les couches semiconductrices 44 sont dopées de type p, il apparaît que seuls les deux premiers puits quantiques du côté de la couche semiconductrice 44 émettent de la lumière en fonctionnement. En effet, pour atteindre un puits quantique donné de la zone active, les trous doivent traverser tous les puits quantiques interposés entre le puits quantique donné et la couche semiconductrice dopée de type p.

La figure 2 représente des courbes d'évolution C1, C2, et C3, obtenues par simulations, de la densité de courant J, exprimée en A/cm², dans des puits quantiques d'une zone active d'une diode électroluminescente d'un dispositif optoélectronique à diodes électroluminescentes en fonction du numéro, N°, désignant le puits quantique. Pour les simulations, le fil 26 était en GaN dopé de type n et la couche semiconductrice 44 était en GaN dopé de type p. La zone active 40 comprenait un empilement de six puits quantiques 50 successifs, désignés par les numéros 1 à 6 sur l'axe des abscisses, le puits quantique 50 désigné par le numéro 1 étant le puits le plus proche du fil semiconducteur 26 et le puits quantique 50 désigné par le numéro 6 étant le puits le plus proche de la couche semiconductrice 44. Chaque puits quantique 50 était en In_{0,14}Ga_{0,86} N et chaque couche barrière 52 était en GaN non intentionnellement dopé. Chaque courbe C1, C2, et C3 a été déterminée selon le modèle de dérive-diffusion (drift-diffusion en anglais) couplé à l'équation de Poisson, comme cela est décrit dans la publication de Chi-Kang Li et al. intitulée "Localization landscape theory of disorder in semiconductors. III. Application to carrier transport and recombination in light emitting diodes" (Physical Review B 95, 144206 (2017)). La courbe C1 a été déterminée en considérant une diminution du champ de polarisation de 50 % par rapport à sa valeur théorique dans un puits quantique supposé de composition uniforme. La courbe C2 a été déterminée en considérant des fluctuations aléatoires de composition chimique dans les puits quantiques. La courbe C3 a été déterminée en considérant les fluctuations de composition chimique dans la formulation du « paysage de potentiel effectif » (landscape potential en anglais). Quelles que soient les variantes théoriques considérées, toutes ces simulations font apparaître que des recombinaisons électrons/trous ne se produisent que dans les deux puits quantiques 50 de numéros 5 et 6, c'est-à-dire les deux puits quantiques 50 les plus proches de la couche semiconductrice 44, qui peuvent donc émettre de la lumière, tandis qu'il n'y a pas de recombinaisons électrons/trous dans les puits quantiques 52 de numéros 1 à 4 qui ne peuvent donc pas émettre de la lumière.

Un exemple de procédé de fabrication du dispositif optoélectronique 10 comprend la croissance des fils 26, des zones actives 40 et des empilements semiconducteurs 42 en mettant en oeuvre un procédé de croissance qui favorise une croissance cristalline selon l'axe C des fils 26. Le procédé de croissance des fils peut être un procédé du type dépôt chimique en phase vapeur (CVD, sigle anglais pour Chemical Vapor Deposition) ou dépôt chimique en phase vapeur aux organométalliques (MOCVD, acronyme anglais pour Metal-Organic Chemical Vapor Deposition), également connu sous le nom d'épitaxie organométallique en phase vapeur (ou MOVPE, acronyme anglais pour Metal-Organic Vapor Phase Epitaxy),ou en MOCVD assistée par plasma (PA-MOCVD), ou un procédé tel que l'épitaxie par jets moléculaires (MBE, acronyme anglais pour Molecular-Beam Epitaxy), la MBE à source de gaz (GSMBE), la MBE organométallique (MOMBE), la MBE assistée par plasma (PA-MBE), dépôt par couches minces atomiques (ALD, acronyme anglais pour Atomic Layer Deposition) ou l'épitaxie en phase vapeur aux hydrures (HVPE, acronyme anglais pour Hydride Vapor Phase Epitaxy ou Halide Vapor Phase Epitaxy) peuvent être utilisés. Toutefois, des procédés électrochimiques peuvent être utilisés, par exemple le dépôt en bain chimique (CBD, sigle anglais pour Chemical Bath Deposition), les procédés hydrothermiques, la pyrolise d'aérosol liquide ou l'électrodépôt.

Les inventeurs ont mis en évidence qu'en mettant en oeuvre un procédé de croissance particulier au moins pour la formation de la zone active 40 et/ou pour la formation de l'empilement semiconducteur 42, il est possible d'obtenir que l'empilement semiconducteur 42 soit directement au contact de chaque puits quantique 50.

Un exemple de procédé de fabrication du dispositif optoélectronique comprend la formation des zones actives 40 en jouant sur les paramètres de croissance pour favoriser une croissance cristalline axiale de sorte que les bords latéraux des puits quantiques soient exposés sur les côtés et la formation de l'empilement semiconducteur 42 en jouant sur les paramètres de croissance pour favoriser une croissance cristalline sur le sommet de la zone active et sur les faces latérales de la zone active. Les couches semiconductrices de l'empilement semiconducteur 42 viennent alors en contact mécanique avec les bords latéraux des puits quantiques. L'injection de trous dans chaque puits quantique peut donc se produire par les bords latéraux du puits quantique. De plus, la surface d'échange entre l'empilement 42 et la zone active 40 est augmentée par rapport à la surface d'échange de type figure 1 qui correspond à une surface de contact entre deux plans.

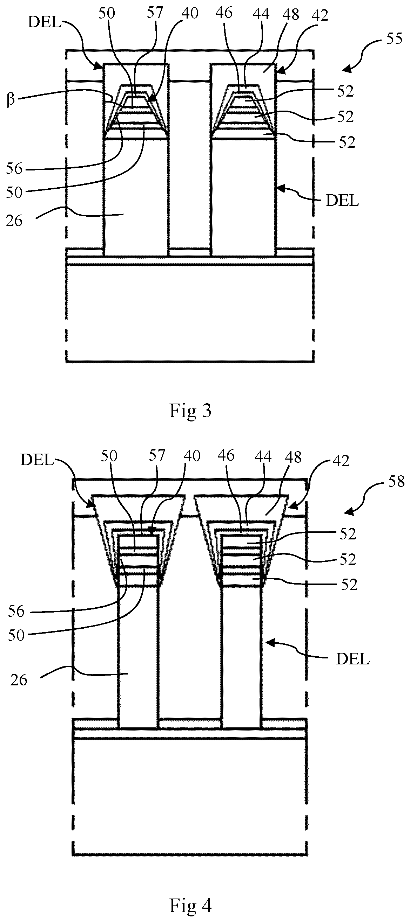

La figure 3 est une vue en coupe, partielle et schématique, d'un mode de réalisation d'un dispositif optoélectronique 55 selon la présente invention. Le dispositif optoélectronique 55 comprend l'ensemble des éléments du dispositif optoélectronique 10 représenté en figure 1 à la différence que la zone active 40 a une forme pyramidale ayant des flancs inclinés 56 et un sommet 57. Dans la zone active 40, les couches formant les puits quantiques 50 et les couches barrière 52 sont sensiblement planes. L'empilement 42 des couches 44, 46, et 48 recouvre les flancs 56 et le sommet 57 de la zone active 40. De ce fait, les couches 44 et 46 sont situées en regard des bords latéraux de chaque puits quantique 50. Les flancs 56 sont inclinés d'un angle β par rapport à l'axe C du fil 26. Selon un mode de réalisation, l'angle β est compris entre strictement supérieur à 0° et 80°, de préférence entre 10° et 45°, plus préférentiellement entre 20° et 30°. Ce permet de façon avantageuse d'obtenir une zone de contact entre l'empilement 42 et chaque puits quantique 50. La conduction électrique et la distribution électrique sont ainsi améliorées dans l'ensemble des puits quantiques 50 de la zone active 40 sur la totalité de la zone active 40. En particulier, la zone active 40 peut présenter une forme de pyramide à étages, ou de pyramide tronquée à étages. Chaque étage correspond à un puits quantique 50 ou à une couche barrière 52 ayant une paroi supérieure sensiblement perpendiculaire à la direction C et une paroi latérale pouvant être sensiblement parallèle à la direction C.

La figure 4 est une vue en coupe, partielle et schématique, d'un mode de réalisation d'un dispositif optoélectronique 58, ne faisant pas partie de la présente invention telle que revendiquée mais illustrant son contexte. Le dispositif optoélectronique 58 comprend l'ensemble des éléments du dispositif optoélectronique 55 représenté en figure 3 à la différence que la zone active 40 a la même forme que la zone active 40 du dispositif optoélectronique 10 représentée en figure 1, c'est-à-dire présentant une géométrie cylindrique à base cylindrique, carré, hexagonale, etc., notamment une géométrie de prisme droit. L'empilement 42 des couches 44, 46, et 48 recouvre les flancs 56 et le sommet 57 de la zone active 40. De ce fait, les couches 44, 46, et 48 sont situées en regard des bords latéraux de chaque puits quantique 50. Un avantage du dispositif optoélectronique 55 selon la présente invention représenté en figure 3 par rapport au dispositif optoélectronique 58 représenté en figure 4 est que les risques de formation de passages pour le courant entre l'empilement semiconducteur 42 et le fil 26 sont réduits. En outre, l'épaisseur des parties de l'empilement 42 au niveau des flancs 56 de la zone active 40 peut être supérieure pour le dispositif optoélectronique 55 représenté en figure 3 par rapport au dispositif optoélectronique 58 représenté en figure 4, ce qui permet de réduire la résistance électrique de ces parties.

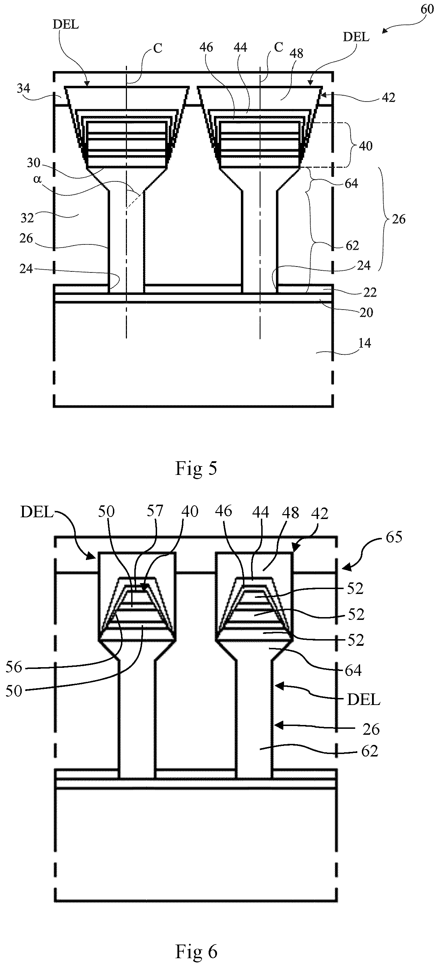

La figure 5 est une vue en coupe d'un mode de réalisation d'un dispositif optoélectronique 60, ne faisant pas partie de la présente invention telle que revendiquée mais illustrant son contexte. Le dispositif optoélectronique 60 comprend l'ensemble des éléments du dispositif optoélectronique 10 représenté en figure 1 à la différence que chaque fil 26 comprend une portion inférieure 62 de section droite sensiblement constante se prolongeant par une portion supérieure 64 de forme évasée vers l'extérieur dans laquelle la section droite augmente selon l'axe C en s'éloignant du substrat 14. Comme cela apparaît sur cette figure, les couches de l'empilement semiconducteur 42 ne s'étendent pas au contact du fil 26 au moins au niveau du sommet du fil 26. Dans le mode de réalisation représenté en figure 5, la portion supérieure 64 comprend des facettes sensiblement planes inclinées par rapport à l'axe C d'un angle α. De façon générale, on appelle angle de la portion supérieure 64 le demi-angle au sommet du tronc de cône d'axe C à base circulaire dans lequel est inscrite la portion supérieure 64. Selon un mode de réalisation, l'angle α est strictement supérieur à 0°, de préférence entre 5° et 50°, plus préférentiellement entre 5° et 30°.

De préférence, pour chaque fil 26, le sommet 30 de la portion supérieure 64 du fil 26 correspond à une face sensiblement plane orthogonale à l'axe C du fil 26. De préférence, la surface du sommet 30 est supérieure d'au moins 20 % à la section droite de la portion inférieure 62 du fil 26. La hauteur de la portion supérieure 64 de chaque fil 26 mesurée selon l'axe C peut être comprise entre 5 nm et 2 µm, de préférence entre 20 nm et 500 nm. La hauteur de la portion inférieure 62 de chaque fil 26 mesurée selon l'axe C peut être comprise entre 200 nm et 5 µm. Pour chaque fil 26, le diamètre moyen de la portion inférieure 62 du fil 26, qui est le diamètre du disque de même surface que la section droite du fil 26, peut être compris entre 50 nm et 10 µm, de préférence entre 100 nm et 2 µm, de préférence entre 100 nm et 1 µm. La section droite de la portion inférieure 62 du fil 26 peut avoir différentes formes, par exemple ovale, circulaire ou polygonale, en particulier rectangulaire, carrée ou hexagonale.

La figure 6 est une vue en coupe, partielle et schématique, d'un mode de réalisation d'un dispositif optoélectronique 65 selon la présente invention. Le dispositif optoélectronique 65 comprend l'ensemble des éléments du dispositif optoélectronique 55 représenté en figure 3 à la différence que le fil 26 a la structure du fil 26 du dispositif optoélectronique 60 représenté en figure 5.

Les fils 26, les couches semiconductrices 44 et les couches de liaison 48 peuvent être, au moins en partie, formés à partir de matériaux semiconducteurs comportant majoritairement un composé III-V, par exemple un composé III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple le phosphore ou l'arsenic. De façon générale, les éléments dans le composé III-V peuvent être combinés avec différentes fractions molaires. Les composés III-V des fils et des couches 44, 48 peuvent comprendre un dopant, par exemple du silicium qui est un dopant de type n pour les composés III-N ou du magnésium qui est un dopant de type p pour les composés III-N.

Le matériau semiconducteur du puits quantique ou des puits quantiques de la zone active 40 peut comprendre le composé III-V du fil 26 et de la couche semiconductrice 44 dans lequel au moins un deuxième élément du groupe III est incorporé. A titre d'exemple, dans le cas de fils 26 constitués de GaN, le deuxième élément est par exemple l'indium (In). Le pourcentage atomique du deuxième élément est fonction des propriétés optiques souhaitées et du spectre d'émission de la diode électroluminescente DEL. Lorsque la portion supérieure 64 du fil 26 n'est pas intentionnellement dopée, celle-ci peut remplacer l'une des couches barrières de la zone active 40.

La couche de blocage d'électrons 46 peut être formée en un alliage ternaire, par exemple en nitrure de gallium et d'aluminium (AlGaN) ou en nitrure d'indium et d'aluminium (AlInN).

Le substrat 14 peut correspondre à une structure monobloc ou correspondre à une couche recouvrant un support constitué d'un autre matériau. Le substrat 14 est de préférence un substrat semiconducteur, par exemple un substrat en silicium, en germanium, en carbure de silicium, en un composé III-V, tel que du GaN ou du GaAs, ou un substrat conducteur, par exemple un substrat métallique, notamment en cuivre, en titane, en molybdène, en un alliage à base de nickel ou en acier, ou un substrat en saphir. De préférence, le substrat 14 est un substrat de silicium monocristallin. De préférence, il s'agit d'un substrat semiconducteur compatible avec les procédés de fabrication mis en oeuvre en microélectronique. Le substrat 14 peut correspondre à une structure multicouches de type silicium sur isolant, également appelée SOI (acronyme anglais pour Silicon On Insulator).

La couche de germination 20 est en un matériau favorisant la croissance des fils 26. A titre d'exemple, le matériau composant la couche de germination 20 peut être un nitrure, un carbure ou un borure d'un métal de transition de la colonne IV, V ou VI du tableau périodique des éléments ou une combinaison de ces composés. A titre d'exemple, la couche de germination 20 peut être en nitrure d'aluminium (AlN). La couche de germination 20 peut avoir une structure monocouche ou correspondre à un empilement de deux couches ou de plus de deux couches.

La couche isolante 22 peut être en un matériau diélectrique, par exemple en oxyde de silicium (SiO₂) ou en nitrure de silicium (SiₓN_{y}, où x est environ égal à 3 et y est environ égal à 4, par exemple du Si₃N₄). A titre d'exemple, l'épaisseur de la couche isolante 22 est comprise entre 5 nm et 100 nm, par exemple égale à environ 30 nm. La couche isolante 22 peut avoir une structure monocouche ou correspondre à un empilement de deux couches ou de plus de deux couches.

La couche isolante 32 peut être en un matériau diélectrique, par exemple en oxyde de silicium (SiO₂) ou en nitrure de silicium (SiₓN_{y}, où x est environ égal à 3 et y est environ égal à 4, par exemple du Si₃N₄). La couche isolante 32 peut avoir une structure monocouche ou correspondre à un empilement de deux couches ou de plus de deux couches. A titre d'exemple, la couche isolante 32 peut être constituée d'un matériau polymère, d'un matériau inorganique ou d'une combinaison d'un matériau polymère et d'un matériau inorganique. A titre d'exemple, le matériau inorganique peut être de l'oxyde de titane (TiO₂) ou de l'oxyde d'aluminium (AlₓO_{y}, où x est environ égal à 2 et y est environ égal à 3, par exemple du Al₂O₃).

La couche d'électrode 34 est adaptée à polariser la zone active 40 recouvrant chaque fil 26 et à laisser passer le rayonnement électromagnétique émis par les diodes électroluminescentes DEL. Le matériau formant la couche d'électrode 34 peut être un matériau transparent et conducteur tel que de l'oxyde d'indium-étain (ou ITO, acronyme anglais pour Indium Tin Oxide), de l'oxyde de zinc dopé ou non à l'aluminium ou au gallium, ou du graphène. A titre d'exemple, la couche d'électrode 34 a une épaisseur comprise entre 5 nm et 200 nm, de préférence entre 20 nm et 50 nm.

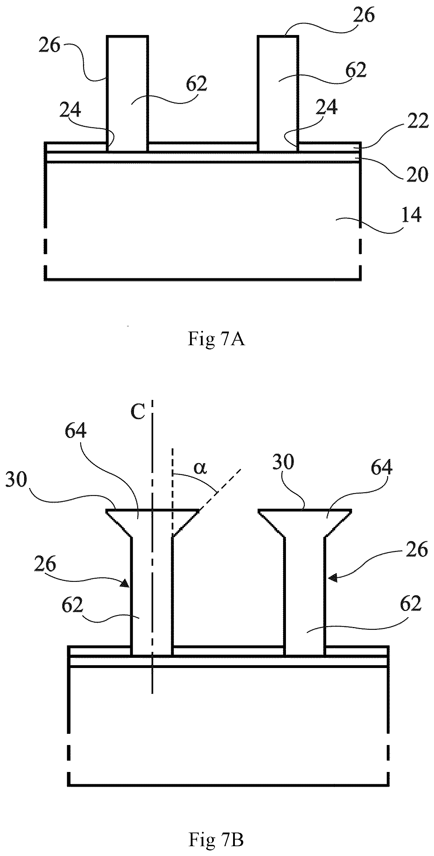

Les figures 7A à 7D sont des vues en coupe, partielles et schématiques, de la structure obtenue à des étapes successives d'un mode de réalisation d'un procédé, ne définissant pas en soi la présente invention telle que revendiquée mais illustrant son contexte, de fabrication du dispositif optoélectronique 60 représenté en figure 5.

La figure 7A représente la structure obtenue après les étapes suivantes :
- formation sur le substrat 14 de la couche de germination 20 ;
- formation de la couche isolante 22 sur la couche de germination 20 ;
- formation des ouvertures 24 dans la couche isolante 22 pour exposer des portions de la couche de germination 20 aux emplacements souhaités des fils 26, le diamètre des ouvertures 24 correspondant sensiblement au diamètre moyen des portions inférieures 62 des fils 26 ; et
- croissance des portions inférieures 62 des fils 26 à partir de la couche de germination 20 dans les ouvertures 24.

La couche de germination 20 et la couche isolante 22 peuvent être formées par CVD, dépôt physique en phase vapeur (PVD, signe anglais pour Physical Vapor Deposition) ou ALD.

Selon un mode de réalisation, la croissance des portions inférieures 62 des fils 26 est réalisée par PA-MBE. La structure est en rotation dans le réacteur autour d'un axe vertical. La pression dans le réacteur est comprise entre 10⁻⁴ Torr (13,3 mPa) et 10⁻⁷ Torr (0,0133 mPa). Les conditions de croissance dans le réacteur sont adaptées pour favoriser une croissance préférentielle de la portion inférieure 62 de chaque fil 26 selon son axe C. Cela signifie que la vitesse de croissance du fil 26 selon l'axe C est nettement supérieure, de préférence d'au moins un ordre de grandeur, à la vitesse de croissance du fil 26 selon une direction perpendiculaire à l'axe C. Le rapport III/V est de préférence inférieur à 1,4, notamment compris entre 0,3 et 1,4, plus préférentiellement compris entre 0,35 et 1, par exemple égal à environ 0,8. La température dans le réacteur est, par exemple, comprise entre 600°C et 1000°C, de préférence entre 700°C et 950°C, plus préférentiellement entre 800°C et 925°C, par exemple environ 900°C.

La figure 7B représente la structure obtenue après la croissance des portions supérieures 64 des fils 26. Selon un mode de réalisation, la croissance des portions supérieures 64 des fils 26 est réalisée par PA-MBE. La structure est en rotation dans le réacteur autour d'un axe vertical. La pression dans le réacteur est comprise entre 10⁻⁴ et 10⁻⁷ Torr. Le rapport III/V est de préférence supérieur à 1,1, notamment compris entre 1,1 et 2, plus préférentiellement compris entre 1,3 et 1,6, par exemple égal à environ 1,4. La température dans le réacteur est inférieure à la température utilisée pour la formation des portions inférieures 62 des fils lorsqu'ils sont réalisés par MBE, de préférence d'au moins 50°C, par exemple comprise entre 550°C et 950°C, de préférence entre 650°C et 900°C, plus préférentiellement entre 750°C et 875°C, par exemple environ 850°C. Ceci permet d'obtenir un élargissement de la portion supérieure 64 de chaque fil 26, de préférence d'au moins 20 %. On obtient alors une portion supérieure 64 dont la paroi latérale forme l'angle α avec l'axe C comme cela a été décrit précédemment.

De façon avantageuse, lorsque les portions supérieures 64 des fils 26 sont formées par PA-MBE, les dimensions de la surface du sommet 30 de chaque portion supérieure 64, où est formée la zone active 40, sont sensiblement fixées par le rapport III/V utilisé pour la formation de la portion supérieure 64, et sont sensiblement indépendantes du diamètre moyen de la portion inférieure 62 du fil 26 depuis laquelle s'étend la portion supérieure 64. Ceci permet donc de commander avec précision les dimensions de la surface du sommet 30 de la portion supérieure 64 et donc les dimensions latérales de la zone active 40. Ceci permet de compenser au moins partiellement les variations des diamètres moyens des portions inférieures 62 des fils 26 qui peuvent résulter du procédé de fabrication des fils.

En outre, la longueur d'onde du rayonnement émis par un puits quantique dépend notamment de la proportion du deuxième élément du groupe III, par exemple l'indium, incorporé dans le composé ternaire du puits quantique. Cette proportion dépend elle-même des dimensions latérales de la zone active 40. De ce fait, un contrôle précis des dimensions latérales de la zone active 40 permet de contrôler avec précision la longueur d'onde du rayonnement émis par la zone active 40. Les variations des longueurs d'ondes du rayonnement émis par les diodes électroluminescentes peuvent donc être réduites.

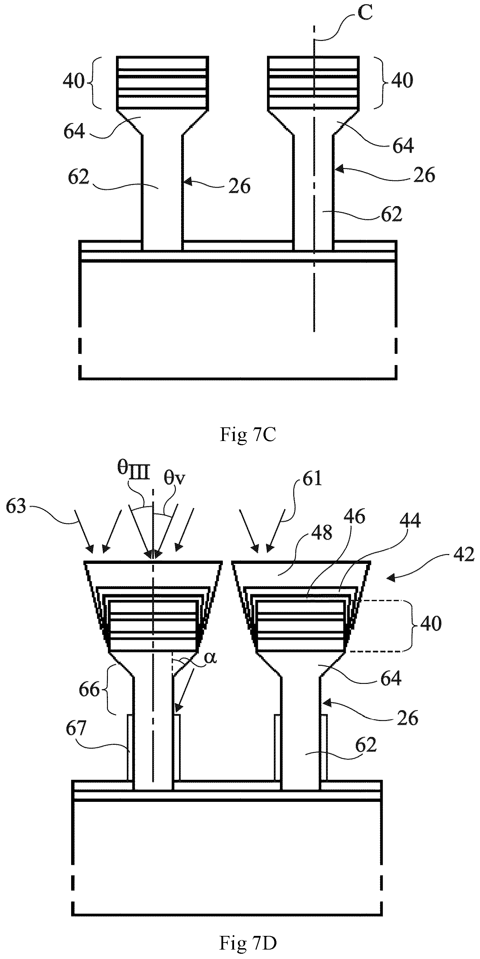

La figure 7C représente la structure obtenue après la croissance des couches des zones actives 40. Selon un mode de réalisation, la croissance des couches des zones actives 40 par un procédé de croissance sous vide à une pression inférieure à 1,33 mPa (10⁻⁵ Torr), de préférence inférieure à 0,0133 mPa (10⁻⁷ Torr), pour lesquels des jets moléculaires sont projetés sur les surfaces sur lesquelles une croissance cristalline est souhaitée. Le procédé de croissance est par exemple la MBE ou la PA-MBE. La structure est en rotation dans le réacteur autour d'un axe vertical. En raison des faibles pressions, les jets moléculaires ont un comportement quasi-balistique. De ce fait, la forme évasée du sommet du fil 26 forme un écran bloquant les jets moléculaires et empêchant la formation des couches semiconductrices de l'empilement semiconducteur 42 sur les parois latérales du fil 26 au moins au niveau du sommet du fil 26. Selon un mode de réalisation, la croissance des couches des zones actives 40 est réalisée par PA-MBE. La pression dans le réacteur est comprise entre 10⁻⁴ et 10⁻⁷ Torr. Pour la formation de chaque puits quantique, un deuxième élément du groupe III est ajouté dans le réacteur. Le rapport entre les flux atomiques des éléments du groupe III et le flux atomique de l'élément du groupe V est égal au flux III/V utilisé pour la formation des portions supérieures 64 des fils 26 lorsqu'elles sont réalisées par MBE. La température dans le réacteur est, par exemple, comprise entre 500°C et 750°C, de préférence entre 600°C et 700°C. Selon un mode de réalisation, pour la formation de chaque puits quantique 50, le rapport entre le flux atomique de l'élément du groupe III du composé III-V et le flux atomique de l'élément du groupe V est inférieur à 1, de préférence compris entre 0,1 et 0,5, de préférence compris entre 0,15 et 0,25. En outre, pour la formation de chaque puits quantique 50, un deuxième élément du groupe III est ajouté dans le réacteur, par exemple In. Le rapport entre le flux atomique du deuxième élément et le flux atomique de l'élément du groupe V est compris entre 0,5 et 2, de préférence entre 0,9 et 1,2. Selon un mode de réalisation, pour la formation de chaque couche barrière 52, le rapport entre le flux atomique de l'élément du groupe III du composé III-V et le flux atomique de l'élément du groupe V est compris entre 0,5 et 1,2, de préférence compris entre 0,8 et 1. Selon un mode de réalisation, pour la formation de chaque couche barrière 52, le flux atomique du deuxième élément du groupe III est nul.

La figure 7D représente la structure obtenue après la croissance des couches des empilements semiconducteurs 42. Selon un mode de réalisation, la croissance des couches des empilements semiconducteurs 42 est réalisée par PA-MBE. La structure est en rotation dans le réacteur autour d'un axe vertical. La pression dans le réacteur est comprise entre 10⁻⁴ et 10⁻⁷ Torr. Pour la formation de la couche de blocage d'électrons 46, un troisième élément du groupe III est ajouté dans le réacteur, le rapport III/V est de préférence proche de 1 et le rapport entre le flux atomique du troisième élément et le flux atomique de l'élément du groupe V est compris entre 0,1 et 0,3. Pour la formation de la couche de blocage d'électrons 46, la température dans le réacteur est, par exemple, comprise entre 600°C et 1000°C, de préférence entre 700°C et 950°C, plus préférentiellement entre 750°C et 900°C. Pour la formation de la couche semiconductrice 44 ou 48, le rapport III/V est de préférence inférieur à 1,3, notamment compris entre 0,8 et 1,3. Pour la formation de la couche semiconductrice 44 ou 48, la température dans le réacteur est, par exemple, comprise entre 600°C et 900°C, de préférence entre 650°C et 750°C. Les flux atomiques de l'élément du groupe III et de l'élément du groupe V sont représentés de façon schématique en figure 7D par des flèches 63, 61. On appelle θ_{III} l'angle d'incidence du flux atomique de l'élément du groupe III et θᵥ celui du flux atomique de l'élément du groupe V par rapport à l'axe C des fils. Les angles θ_{III} et θᵥ dépendent notamment du type de réacteur utilisé. Lorsque le plus grand des angles θ_{III} et θᵥ est inférieur à l'angle α, on obtient une zone 66 sur la portion inférieure 62 de chaque fil 26 où il n'y a pas de dépôt alors que l'on peut observer la formation d'un dépôt 67 non souhaité en partie basse de la portion inférieure 62 de chaque fil 26. Pour chaque fil 26, il n'y a pas de continuité entre les couches semiconductrices de l'empilement semiconducteur 42 et le dépôt 67 formé simultanément sur les parois latérales du fil 26, de sorte que la formation d'un court-circuit est empêchée.

Sur les figures 7C et 7D, on a représenté chaque zone active 40 avec une section droite sensiblement constante selon l'axe C. A titre de variante et selon, cette fois-ci, la présente invention telle que revendiquée, les conditions de croissance de la zone active 40 peuvent être sélectionnées de façon que la zone active 40 ait une forme de pyramide tronquée d'axe C avec une section droite qui diminue selon l'axe C en s'éloignant du substrat 14. Une telle forme peut être obtenue sans perte notable du volume du puits quantique ou des puits quantiques par rapport au cas où la section droite est constante. Une zone active 40 en forme de pyramide tronquée permet, de façon avantageuse, d'augmenter l'épaisseur de la couche semiconductrice 44 qui la recouvre et d'améliorer la passivation de la surface de la zone active 40.

Selon un autre mode de réalisation, la croissance des portions inférieures 62 des fils 26, et/ou des portions supérieures 64 des fils 26, et/ou des zones actives 40 est réalisée par un autre procédé qu'un procédé de dépôt en phase vapeur à une pression inférieure à 1,33 mPa (10^{- 5} Torr), notamment par PA-MBE. Le procédé de croissance doit néanmoins permettre la formation de la portion supérieure 64 évasée de chaque fil 26.

Selon un autre mode de réalisation, la croissance des portions inférieures 62 des fils 26, et/ou des portions supérieures 64 des fils 26, et/ou des zones actives 40 est réalisée par MOCVD, par MBE, notamment MBE assistée par ammoniac, par épitaxie en couches minces atomiques (ALE, sigle anglais pour atomic layer epitaxy) . A titre d'exemple, le procédé peut comprendre l'injection dans un réacteur d'un précurseur d'un élément du groupe III et d'un précurseur d'un élément du groupe V. Des exemples de précurseurs d'éléments du groupe III sont le triméthylgallium (TMGa), le triéthylgallium (TEGa), le triméthylindium (TMIn) ou le triméthylaluminium (TMAl). Des exemples de précurseurs d'éléments du groupe V sont l'ammoniac (NH₃), le tertiarybutylphosphine (TBT), l'arsine (AsH₃), ou le diméthylhydrazine asymétrique (UDMH). On appelle rapport III/V le rapport entre le flux de gaz du précurseur de l'élément du groupe III et le flux de gaz du précurseur de l'élément du groupe V.

Un mode de réalisation d'un procédé de fabrication du dispositif optoélectronique 58 représenté sur la figure 4 peut comprendre les mêmes étapes que celles décrites précédemment pour la fabrication du dispositif optoélectronique 60 en relation avec les figures 7A à 7D à la différence que les fils 26 ont une section droite sensiblement constante et peuvent être réalisés par CVD, MOCVD, PA-MOCVD, MBE, GSMBE, PA-MBE, ALD, HVPE, CBD, les procédés hydrothermiques, la pyrolise d'aérosol liquide ou l'électrodépôt.

Un mode de réalisation d'un procédé de fabrication du dispositif optoélectronique 55 selon la présente invention représenté sur la figure 3 peut comprendre les mêmes étapes que celles décrites précédemment pour la fabrication du dispositif optoélectronique 60 en relation avec les figures 7A à 7D à la différence des étapes de fabrication des fils 26 et des étapes de fabrication des zones actives 40. Les fils 26 peuvent être réalisés comme cela a été décrit précédemment pour les fils 26 du dispositif optoélectronique 58 représenté sur la figure 4.

Selon un mode de réalisation, chaque puits quantique 50 est formé par PA-MBE. La température de croissance est comprise entre 500°C et 800°C, de préférence entre 600°C et 700°C. La pression dans le réacteur est comprise entre 10⁻⁷ Torr (0,0133 mPa) et 5.10⁻⁴ Torr (66,5 mPa). Selon un mode de réalisation, pour la formation de chaque puits quantique 50 et de chaque couche barrière 52, le rapport entre le flux atomique de l'élément du groupe III du composé III-V et le flux atomique de l'élément du groupe V est inférieur à 1, de préférence compris entre 0,15 et 0,5, de préférence compris entre 0,15 et 0,25. En outre, pour la formation de chaque puits quantique 50, un deuxième élément du groupe III est ajouté dans le réacteur, par exemple In. Le rapport entre le flux atomique du deuxième élément du groupe III et le flux atomique de l'élément du groupe V est compris entre 0,5 et 2,85, de préférence entre 0,9 et 1,2. Le fait que le rapport entre le flux atomique de l'élément du groupe III du composé III-V et le flux atomique de l'élément du groupe V soit inférieur à 1 permet d'obtenir une zone active 40 ayant la forme générale d'une pyramide ou d'une pyramide tronquée. Selon un mode de réalisation, pour la formation de chaque couche barrière 52, le flux atomique du deuxième élément du groupe III est nul. Les conditions de croissance décrites précédemment permettent de favoriser la croissance des puits quantiques 50 et des couches barrières 52 selon une direction de croissance parallèle à l'axe C et de réduire, voire de supprimer, la croissance cristalline selon des plans semi-polaires ou non-polaires.

Un mode de réalisation d'un procédé de fabrication du dispositif optoélectronique 65 selon la présente invention représenté sur la figure 6 peut comprendre les mêmes étapes que celles décrites précédemment pour la fabrication du dispositif optoélectronique 60 en relation avec les figures 7A à 7D à la différence que les zones actives 40 sont formées comme cela a été décrit précédemment pour le dispositif optoélectronique 55.

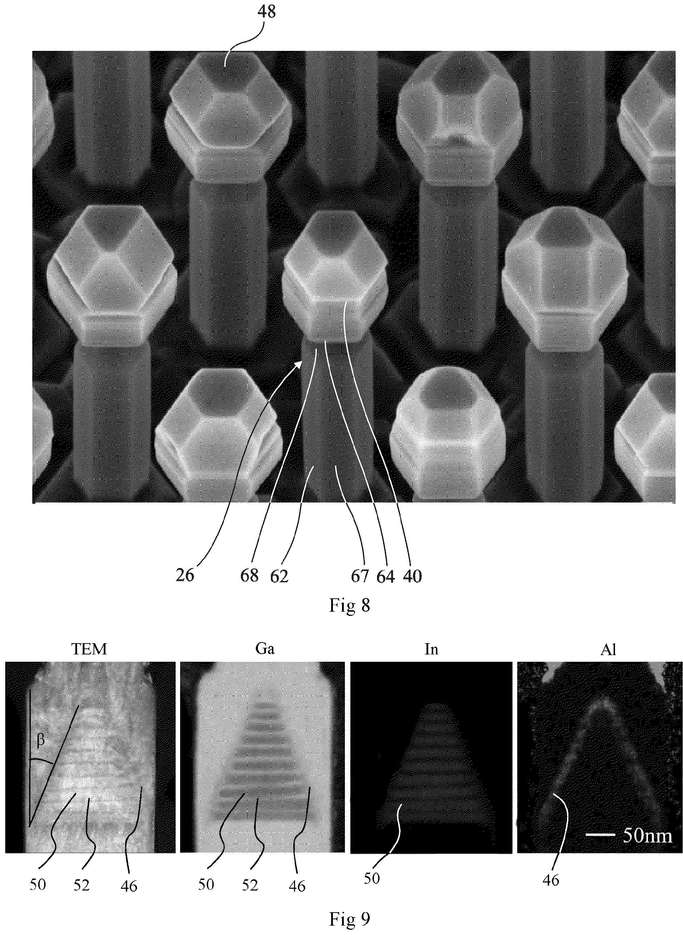

La figure 8 est une image, obtenue par microscopie électronique à balayage, de l'extrémité supérieure de fils 26, des zones actives 40 et des empilements semiconducteurs 42 formés par MBE comme cela a été décrit précédemment en relation avec les figures 7A à 7D. Les portions inférieures 62 des fils 26 étaient en GaN dopé de type n. Le diamètre moyen de la portion inférieure 62 de chaque fil 26 était sensiblement égal à 200 nm. Les portions supérieures 64 des fils 26 étaient en GaN dopé de type n. Chaque zone active 40 comprenait dix puits quantiques en InGaN avec des couches barrières de GaN non dopé intentionnellement. Chaque empilement semiconducteur 42 comprenait une couche de blocage 46 en AlGaN et une couche semiconductrice 44 en GaN dopé de type p.

Les portions inférieures 62 des fils 26 ont été formées par MOCVD avec un rapport III/V de 0,1 et une température de 1050°C. Les portions supérieures 64 des fils 26 ont été formées par MBE avec un rapport Ga/N de 1,6 et une température de 850°C. Les puits quantiques en InGaN ont été formés par MBE avec un rapport (Ga+In)/N de 1,6 et une température de 750°C. Les couches de blocage 46 en AlGaN ont été formées par MBE avec un rapport (Ga+Al)/N de 1. Les couches semiconductrices 44 de GaN dopé de type p ont été formées par MBE avec un rapport Ga/N de 1 et une température de 850°C.

Comme cela apparaît sur la figure 8, on observe, pour chaque fil 26, un élargissement de la portion supérieure 64 du fil 26. En outre, on observe un dépôt 67 de GaN de type p sur les parois latérales du fil 26 seulement en partie basse du fil 26. La zone étranglée 68 du fil 26 correspond à la partie du fil 26 dans laquelle il n'y a pas de dépôt de GaN de type p en raison de l'ombrage fait par la portion supérieure 64 du fil 26.

La figure 9 représente des images de l'extrémité supérieure de fils 26, d'une zone active 40 et de l'empilement semiconducteur 42 du dispositif optoélectronique 55 selon la présente invention représenté en figure 3. Le fil 26 était en GaN dopé de type n. Chaque puits quantique 50 était en InGaN. Chaque couche barrière 52 était en GaN. La couche de blocage d'électrons 46 était en AlGaN. La couche semiconductrice 44 était en GaN dopé de type p. Plus précisément, la figure 9 représente, de gauche à droite, une image TEM obtenue par microscopie électronique en transmission à balayage (STEM, Scanning Transmission Electron Microscopy), une image Ga obtenue par spectroscopie de rayons X à dispersion d'énergie (EDX, Energy Dispersive X-Ray) pour l'élément Ga, une image In obtenue par spectroscopie EDX pour l'élément In, et une image Al obtenue par spectroscopie EDX pour l'élément Al. Pour les images de la figure 9, l'angle β était environ égal à 23°.

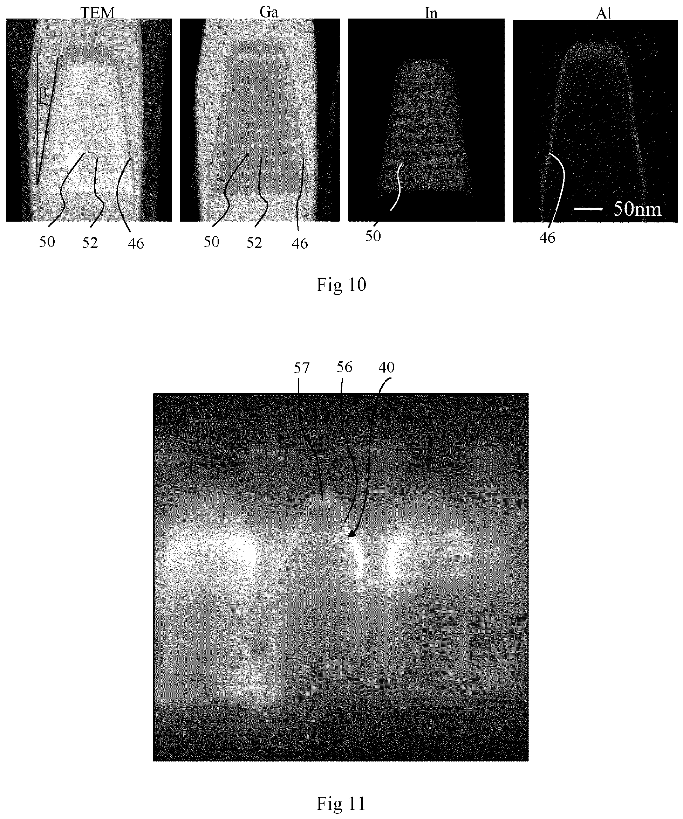

La figure 10 représente des images analogues à celles de la figure 9 obtenues avec un dispositif optoélectronique 55 selon la présente invention pour lequel l'angle β était environ égal à 9°.

Sur chacune des figures 9 et 10, la couche de blocage d'électrons 46 est en contact avec les bords de chaque puits quantique 50.

La figure 11 est une image en courant induit par faisceau d'électrons (EBIC, Electron beam-induced current) de l'extrémité d'une diode électroluminescente du dispositif optoélectronique selon la présente invention représenté en figure 3. Comme cela apparaît sur cette figure, un champ électrique est présent au sommet 57 et sur les flancs 56 de la zone active 40 indiquant l'injection de trous dans la zone active 40 à la fois par le sommet 57 et par les flancs 56.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. Enfin, la mise en oeuvre pratique des modes de réalisation et variantes décrits est à la portée de l'homme du métier à partir des indications fonctionnelles données ci-dessus.

Les revendications qui suivent définissent l'objet de la présente invention.

## Revendications

1. Dispositif optoélectronique (55 ; 65) comprenant une ou des diodes électroluminescentes (DEL), chaque diode électroluminescente comprenant un élément semiconducteur tridimensionnel (26), une zone active (40) reposant sur l'élément semiconducteur tridimensionnel et un empilement (42) de couches semiconductrices recouvrant la zone active, la zone active comprenant une pluralité de puits quantiques (50), ledit empilement étant au contact physique direct de plusieurs puits quantiques, dans lequel chaque zone active (40) comprend une base, des flancs (56), et un sommet (57), la base reposant sur l'élément semiconducteur tridimensionnel (26), les puits quantiques comprenant des bords exposés sur les flancs, ledit empilement (42) recouvrant les flancs et le sommet,
le dispositif optoélectronique (55; 65) étant **caractérisé en ce que**: chaque zone active (40) a une forme de pyramide ou pyramide tronquée de demi-angle au sommet β dont la base repose sur l'élément semiconducteur tridimensionnel (26).

2. Dispositif selon la revendication 1, dans lequel l'angle β est strictement supérieur à 0°, de préférence compris entre 5° et 80°, plus préférentiellement compris entre 20° et 30°.

3. Dispositif selon la revendication 2, dans lequel l'empilement (42) de couches semiconductrices comprend une paroi latérale parallèle à la direction de croissance C des matériaux cristallins composant les couches semiconductrices de l'empilement.

4. Dispositif selon l'une quelconque des revendications 1 à 3, dans lequel les éléments semiconducteurs tridimensionnels (26) s'étendent selon des axes parallèles, et comprennent chacun une portion inférieure (62) et une portion supérieure (64) évasée par rapport à la portion inférieure et inscrite dans un tronc de cône de demi-angle au sommet α.

5. Dispositif selon la revendication 4, dans lequel l'angle α est strictement supérieur à 0°, de préférence compris entre 5° et 50°, plus préférentiellement compris entre 5° et 30°.

6. Dispositif selon l'une quelconque des revendications 1 à 5, dans lequel au moins une partie de chaque élément semiconducteur tridimensionnel (26) est un microfil, un nanofil, ou un élément tronconique de taille micrométrique ou nanométrique.

7. Dispositif selon l'une quelconque des revendications 1 à 6, dans lequel les éléments semiconducteurs tridimensionnels (26) comprennent un composé III-V.

8. Dispositif selon l'une quelconque des revendications 1 à 7, dans lequel les éléments semiconducteurs tridimensionnels (26) sont dopés de type n.

9. Dispositif selon la revendication 8, dans lequel chaque empilement (42) comprend une couche semiconductrice (44) en un composé III-V dopé de type p.

10. Dispositif selon l'une quelconque des revendications 1 à 9, dans lequel chaque empilement (42) comprend au moins une couche de blocage d'électrons (46).

11. Dispositif selon la revendication 10, dans lequel chaque puits quantique (50) comprend un alliage ternaire comprenant un premier élément du groupe III, l'élément du groupe V du composé III-V, et un deuxième élément du groupe III.

12. Dispositif selon l'une quelconque des revendications 1 à 11, comprenant de trois à dix puits quantiques (50).

13. Dispositif selon l'une quelconque des revendications 1 à 12. dans lequel ledit empilement (42) est au contact physique direct de chaque puits quantique (50).

14. Procédé de fabrication d'un dispositif optoélectronique (55 ; 65) comprenant une ou des diodes électroluminescentes (DEL), comprenant, pour chaque diode électroluminescente, la formation d'un élément semiconducteur tridimensionnel (26), la formation d'une zone active (40) reposant sur l'élément semiconducteur tridimensionnel et la formation d'un empilement (42) de couches semiconductrices recouvrant la zone active, la zone active comprenant une pluralité de puits quantiques (50), ledit empilement étant au contact physique direct de plusieurs puits quantiques, dans lequel chaque zone active (40) comprend une base, des flancs (56), et un sommet (57), la base reposant sur l'élément semiconducteur tridimensionnel (26), les puits quantiques comprenant des bords exposés sur les flancs, ledit empilement (42) recouvrant les flancs et le sommet, et dans lequel chaque zone active (40) a une forme de pyramide ou pyramide tronquée de demi-angle au sommet β dont la base repose sur l'élément semiconducteur tridimensionnel (26).

15. Procédé selon la revendication 14, dans lequel les éléments semiconducteurs tridimensionnels (26) comprennent un composé III-V, dans lequel chaque puits quantique (50) comprend un alliage ternaire comprenant un premier élément du groupe III, l'élément du groupe V du composé III-V, et un deuxième élément du groupe III, dans lequel les puits quantiques sont séparés par des couches barrières (52) comprenant le composé III-V, et dans lequel, pour la croissance de chaque couche barrière (52), le rapport entre le flux atomique de l'élément du groupe III du composé III-V et le flux atomique de l'élément du groupe V est inférieur à 1.

## Patentansprüche

1. Optoelektronische Vorrichtung (55; 65) aufweisend eine oder eine Vielzahl von lichtemittierenden Dioden (DEL), wobei jede lichtemittierende Diode ein dreidimensionales Halbleiterelement (26), einen aktiven Bereich (40), der auf dem dreidimensionalen Halbleiterelement ruht, und einen Stapel (42) von Halbleiterschichten aufweist, der den aktiven Bereich bedeckt, wobei der aktive Bereich eine Vielzahl von Quantentöpfen (50) aufweist, wobei der Stapel in direktem physikalischen Kontakt mit der Vielzahl von Quantentöpfen steht, wobei jeder aktive Bereich (40) eine Basis, Seiten (56) und eine Oberseite (57) aufweist, wobei die Basis auf dem dreidimensionalen Halbleiterelement (26) ruht, die Quantentöpfe an den Seiten freiliegende Kanten aufweisen und der Stapel (42) die Seiten und die Oberseite bedeckt,
wobei die optoelektronische Vorrichtung (55; 65) **dadurch gekennzeichnet ist, dass**: jeder aktive Bereich (40) die Form einer Pyramide oder eines Pyramidenstumpfes mit halbem Scheitelwinkel β hat, deren Basis auf dem dreidimensionalen Halbleiterelement (26) ruht.

2. Die Vorrichtung nach Anspruch 1, wobei der Winkel β größer als 0° ist, vorzugsweise im Bereich von 5° bis 80°, besonders bevorzugt im Bereich von 20° bis 30°.

3. Die Vorrichtung nach Anspruch 2, wobei der Stapel (42) von Halbleiterschichten eine Seitenwand aufweist, die parallel zur Wachstumsrichtung C des kristallinen Materials verläuft, das die Halbleiterschichten des Stapels bildet.

4. Die Vorrichtung nach einem der Ansprüche 1 bis 3, wobei die dreidimensionalen Halbleiterelemente (26) sich entlang paralleler Achsen erstrecken und jeweils einen unteren Abschnitt (62) und einen oberen Abschnitt (64) aufweisen, der sich in Bezug auf den unteren Abschnitt erweitert und in einen Kegelstumpf mit halbem Öffnungswinkel a eingeschrieben ist.

5. Die Vorrichtung nach Anspruch 4, wobei der Winkel a größer als 0° ist, vorzugsweise im Bereich von 5° bis 50°, besonders bevorzugt im Bereich von 5° bis 30°.

6. Die Vorrichtung nach einem der Ansprüche 1 bis 5, wobei wenigstens ein Teil jedes dreidimensionalen Halbleiterelements (26) ein Mikrodraht, ein Nanodraht oder ein kegelstumpfförmiges Element im Mikrometer- oder Nanometerbereich ist.

7. Die Vorrichtung nach einem der Ansprüche 1 bis 6, wobei die dreidimensionalen Halbleiterelemente (26) eine III-V-Verbindung aufweisen.

8. Die Vorrichtung nach einem der Ansprüche 1 bis 7, wobei die dreidimensionalen Halbleiterelemente (26) n-dotiert sind.

9. Die Vorrichtung nach Anspruch 8, wobei jeder Stapel (42) eine Halbleiterschicht (44) aus einer p-dotierten III-V-Verbindung aufweist.

10. Die Vorrichtung nach einem der Ansprüche 1 bis 9, wobei jeder Stapel (42) wenigstens eine elektronensperrende Schicht aufweist.

11. Die Vorrichtung nach Anspruch 10, wobei jeder Quantentopf (50) eine ternäre Legierung aufweist, die ein erstes Gruppe-III-Element, das Gruppe-V-Element der III-V-Verbindung und ein zweites Gruppe-III-Element aufweist.

12. Die Vorrichtung nach einem der Ansprüche 1 bis 11, die drei bis zehn Quantentöpfe (50) aufweist.

13. Die Vorrichtung nach einem der Ansprüche 1 bis 12, wobei der Stapel (42) in direktem physikalischen Kontakt mit jedem Quantentopf (50) steht.

14. Ein Verfahren zum Herstellen einer optoelektronischen Vorrichtung (55; 58; 60; 65) , die eine oder eine Vielzahl von lichtemittierenden Dioden (DEL) aufweist, wobei, für jede lichtemittierende Diode, Bilden eines dreidimensionalen Halbleiterelements (26), Bilden eines aktiven Bereichs (40), der auf dem dreidimensionalen Halbleiterelement ruht, und Bilden eines Stapels (42) von Halbleiterschichten, der den aktiven Bereich bedeckt, aufweist, wobei der aktive Bereich eine Vielzahl von Quantentöpfen (50) aufweist, wobei der Stapel in direktem physikalischen Kontakt mit der Vielzahl von Quantentöpfen steht, wobei jeder aktive Bereich (40) eine Basis, Seiten (56) und eine Oberseite (57) aufweist, wobei die Basis auf dem dreidimensionalen Halbleiterelement (26) ruht, wobei die Quantentöpfe an den Seiten freiliegende Kanten aufweisen, wobei der Stapel (42) die Seiten und die Oberseite bedeckt, und wobei jeder aktive Bereich (40) die Form einer Pyramide oder eines Pyramidenstumpfes mit halbem Scheitelwinkel β hat, deren Basis auf dem dreidimensionalen Halbleiterelement (26) ruht.

15. Das Verfahren nach Anspruch 14, wobei die dreidimensionalen Halbleiterelemente (26) eine III-V-Verbindung aufweisen, wobei jeder Quantentopf (50) eine ternäre Legierung aufweist, die ein erstes Gruppe-III-Element, das Gruppe-V-Element der III-V-Verbindung und ein zweites Gruppe-III-Element aufweist, wobei die Quantentöpfe durch Barriereschichten (52) getrennt sind, die die III-V-Verbindung aufweisen, und wobei für das Wachstum jeder Barriereschicht (52) das Verhältnis des Atomflusses des Gruppe-III-Elements der III-V-Verbindung zu dem Atomfluss des Gruppe-V-Elements kleiner als 1 ist.

## Claims

1. Optoelectronic device (55; 65) comprising one or a plurality of light-emitting diodes (DEL), each light-emitting diode comprising a three-dimensional semiconductor element (26), an active area (40) resting on the three-dimensional semiconductor element and a stack (42) of semiconductor layers covering the active area, the active area comprising a plurality of quantum wells (50), said stack being in direct physical contact with a plurality of quantum wells, wherein each active area (40) comprises a base, sides (56), and a top (57), the base resting on the three-dimensional semiconductor element (26), the quantum wells comprising edges exposed on the sides, said stack (42) covering the sides and the top,
the optoelectronic device (55; 65) being **characterized in that**: each active area (40) has the shape of a pyramid or truncated pyramid of half apical angle β having its base resting on the three-dimensional semiconductor element (26).

2. Device according to claim 1, wherein angle β is greater than 0°, preferably in the range from 5° to 80°, more preferably in the range from 20° to 30°.

3. Device according to claim 2, wherein the stack (42) of semiconductor layers comprises a lateral wall parallel to the growth direction C of the crystalline materials forming the semiconductor layers of the stack.

4. Device according to any of claims 1 to 3, wherein the three-dimensional semiconductor elements (26) extend along parallel axes, and each comprise a lower portion (62) and an upper portion (64) flared with respect to the lower portion and inscribed within a frustum of half apical angle α.

5. Device according to claim 4, wherein angle α is greater than 0°, preferably in the range from 5° to 50°, more preferably in the range from 5° to 30°.

6. Device according to any of claims 1 to 5, wherein at least a portion of each three-dimensional semiconductor element (26) is a microwire, a nanowire, or a micrometer- or nanometer-range frustoconical element.

7. Device according to any of claims 1 to 6, wherein the three-dimensional semiconductor elements (26) comprise a III-V compound.

8. Device according to any of claims 1 to 7, wherein the three-dimensional semiconductor elements (26) are n-type doped.

9. Device according to claim 8, wherein each stack (42) comprises a semiconductor layer (44) made of a p-type doped III-V compound.

10. Device according to any of claims 1 to 9, wherein each stack (42) comprises at least one electron-blocking layer.

11. Device according to claim 10, wherein each quantum well (50) comprises a ternary alloy comprising a first group-III element, the group-V element of the III-V compound, and a second group-III element.

12. Device according to any of claims 1 to 11, comprising from three to ten quantum wells (50).

13. Device according to any of claims 1 to 12, wherein said stack (42) is in direct physical contact with each quantum well (50).

14. Method of manufacturing an optoelectronic device (55; 58; 60; 65) comprising one or a plurality of light-emitting diodes (DEL) comprising, for each light-emitting diode, the forming of a three-dimensional semiconductor element (26), the forming of an active area (40) resting on the three-dimensional semiconductor element, and the forming of a stack (42) of semiconductor layers covering the active area, the active area comprising a plurality of quantum wells (50), said stack being in direct physical contact with a plurality of quantum wells, wherein each active area (40) comprises a base, sides (56), and a top (57), the base resting on the three-dimensional semiconductor element (26), the quantum wells comprising edges exposed on the sides, said stack (42) covering the sides and the top, and wherein each active area (40) has the shape of a pyramid or truncated pyramid of half apical angle β having its base resting on the three-dimensional semiconductor element (26).

15. Method according to claim 14, wherein the three-dimensional semiconductor elements (26) comprise a III-V compound, wherein each quantum well (50) comprises a ternary alloy comprising a first group-III element, the group-V element of the III-V compound, and a second group-III element, wherein the quantum wells are separated by barrier layers (52) comprising the III-V compound, and wherein, for the growth of each barrier layer (52), the ratio of the atomic flux of the group-III element of the III-V compound to the atomic flux of the group-V element is smaller than 1.
